# EUROPÄISCHE PATENTSCHRIFT

(11) **EP 2 837 012 B1**
(45) Veröffentlichungstag und Bekanntmachung des Hinweises auf die Patenterteilung: **04.11.2015**
(21) Anmeldenummer: 13731259.1
(22) Anmeldetag: 11.06.2013
(51) Int. Cl.: H01H 47/00, H02J 3/38

(54) **VERFAHREN ZUR PRÜFUNG EINER TRENNSTELLE EINES PHOTOVOLTAIK-WECHSELRICHTERS UND PHOTOVOLTAIK-WECHSELRICHTER**
METHOD FOR CHECKING A SEPARATION POINT OF A PHOTOVOLTAIC INVERTER, AND PHOTOVOLTAIC INVERTER
PROCÉDÉ DE VÉRIFICATION D'UN POINT DE COUPURE D'UN ONDULEUR PHOTOVOLTAÏQUE ET ONDULEUR PHOTOVOLTAÏQUE

(30) Priorität: 13.06.2012 AT 502322012
(43) Veröffentlichungstag der Anmeldung: 18.02.2015
(73) Patentinhaber: Fronius International GmbH, 4643 Pettenbach (AT)
(72) Erfinder: DANMAYR, Joachim, 4542 Nußbach (AT); BLÖCHL, Stefan, 94572 Schöfweg (DE)
(74) Vertreter: Sonn & Partner Patentanwälte
(86) Internationale Anmeldenummer: PCT/AT2013/050118
(87) Internationale Veröffentlichungsnummer: WO 2013/185160

(56) Entgegenhaltungen:
- WO-A1-2011/065278
- DE-U1-202009 018 199
- US-A1- 2010 226 160
- US-A1- 2011 298 470

## Beschreibung

Die Erfindung betrifft ein Verfahren zur Prüfung einer Trennstelle eines Photovoltaik-Wechselrichters zu einem Energieversorgungsnetz mit mehreren Phasen und einem Neutralleiter, wobei mehrere Schaltkontakte mehrerer Relais der Trennstelle vom Photovoltaik-Wechselrichter angesteuert werden, und die Spannungen an jeder Phase gegenüber dem Neutralleiter jeweils vor und nach der Trennstelle gemessen werden.

Weiters betrifft die Erfindung einen Photovoltaik-Wechselrichter zur Umwandlung einer Gleichspannung in eine Wechselspannung mit mehreren Phasen und einem Neutralleiter und zur Einspeisung der Wechselspannung in ein Energieversorgungsnetz mit mehreren Phasen und einem Neutralleiter, mit einer Trennstelle aus mehreren Relais mit mehreren Schaltkontakten zur galvanischen Trennung zu den Phasen und dem Neutralleiter des Energieversorgungsnetzes, wobei Einrichtungen zur Messung der Spannungen der Phasen gegenüber dem Neutralleiter vor und nach der Trennstelle vorgesehen sind.

Üblicherweise wird als Trennstelle zwischen dem Photovoltaik-Wechselrichter und dem Energieversorgungsnetz eine Anordnung aus jeweils einem Relaispaar pro Phase verwendet, um eine sichere Trennung vom Energieversorgungsnetz zu erreichen. Für die Zulassung zur netzparallelen Einspeisung ist die Einhaltung einschlägiger Normen und Vorschriften vorausgesetzt. Beispielsweise ist in der Norm E DIN VDE 0128 eine Freischaltstelle aus zwei voneinander unabhängigen Einrichtungen zur Netzüberwachung mit zugeordneten Schaltern in Serie vorgeschrieben.

Zusätzlich kann es aus diesen Anforderungen ausgehend ebenfalls notwendig sein, den Neutralleiter auch über ein solches Relaispaar zu schalten, um eine sichere Trennung zu ermöglichen. Insgesamt werden bei einer solchen Trennschaltung, für ein dreiphasiges Wechselstromnetz daher acht voneinander unabhängige Relais benötigt. Weiters ist es laut einschlägiger Normen notwendig, diese Relais regelmäßig auf deren Funktionalität zu prüfen. Dabei werden die Schaltkontakte der Relais auf ein tatsächliches Öffnen und Schließen geprüft.

Die US 2010/0226160 A1 zeigt ein Verfahren zur Prüfung einer Trennstelle eines Photovoltaik-Wechselrichters der gegenständlichen Art, wobei die Spannungen an jeder Phase gegenüber dem Neutralleiter jeweils vor und nach der Trennstelle gemessen werden. Dabei ist ein Rückschluss auf die Funktionalität der Trennstelle des Photovoltaik-Wechselrichters und eine exakte Bestimmung eines allfälligen defekten Schaltkontakts der Trennstelle nicht möglich.

Die Aufgabe der vorliegenden Erfindung besteht in der Schaffung eines oben erwähnten Verfahrens und eines Photovoltaik-Wechselrichters, mit welchen die Funktionalität der Trennstelle ohne zusätzlichen Bauteilaufwand rasch und einfach überprüft werden kann. Die Trennstelle soll darüber hinaus möglichst platzsparend und billig sein.

Gelöst wird diese Aufgabe in verfahrensmäßiger Hinsicht dadurch, dass in der Trennstelle zumindest eine Phase vor der Trennstelle und zumindest eine Phase nach der Trennstelle ausgekreuzt wird die Schaltkontakte der Trennstelle nach einem Schaltmuster schrittweise geschaltet und geprüft werden, wobei das Schaltmuster durch schrittweisen Wechsel der Schaltkontakte der Trennstelle von einem Schaltzustand in einen anderen Schaltzustand realisiert wird und jedem Schaltzustand ein Messergebnis gemäß einer Auswertetabelle zugeordnet wird, und in jedem Schaltzustand des Schaltmusters die Funktionalität der Schaltkontakte der Trennstelle abgeleitet wird, indem bei jedem Schaltzustand die Spannungen an zumindest einer Phase gegenüber dem Neutralleiter jeweils vor und nach der Trennstelle gemessen und mit den Messergebnissen der Auswertetabelle verglichen werden. Dabei wird in vorteilhafter Weise erreicht, die Funktionalität jedes einzelnen Schaltkontakts - auch bei zwei- und mehrpoligen Relais - zu prüfen. Die Trennstelle muss nicht zwingend im Photovoltaik-Wechselrichter integriert sein, wodurch die Baugröße des Photovoltaik-Wechselrichters nicht verändert werden muss. Es kann beispielsweise auch eine Trennstelle im Photovoltaik-Wechselrichter und eine zweite Trennstelle extern angeordnet sein. Dabei erfolgt eine entsprechende Kommunikation zwischen den Trennstellen, sodass die Spannungen übertragen werden können. Entsprechend sind die Trennstellen auch ausgekreuzt. Das Schaltmuster wird durch schrittweisen Wechsel der Schaltkontakte der Trennstelle von einem Schaltzustand in einen anderen Schaltzustand realisiert, in dessen einzelnen Schaltzuständen oder dem Wechsel der Schaltzustände jeweils die Funktionalität der einzelnen Schaltkontakte der Trennstelle abgeleitet wird. Bei jedem Wechsel des Schaltzustands der Schaltkontakte der Trennstelle in Form eines Öffnens oder Schließens der Schaltkontakte wird die Funktionalität der Schaltkontakte der Trennstelle abgeleitet.

Die für die Spannungsmessung erforderlichen Spannungen können vom Energieversorgungsnetz oder vom Photovoltaik-Wechselrichter zur Verfügung gestellt werden.

Gemäß einem Merkmal der Erfindung werden die gemessenen Spannungen vor und nach der Trennstelle durch zwei voneinander unabhängige Controller verarbeitet, welche Controller über einen Datenbus miteinander verbunden werden.

Gelöst wird die erfindungsgemäße Aufgabe auch durch einen oben genannten Photovoltaik-Wechselrichter, wobei die Trennstelle aus vier Relais mit jeweils zumindest einem Schaltkontakt besteht, wobei für jeden Anschluss der Phasen und des Neutralleiters jeweils zwei Schaltkontakte von zwei voneinander unabhängig schaltbaren Relais miteinander in Reihe geschaltet sind, und in der Trennstelle zumindest eine Phase vor der Trennstelle und zumindest eine Phase nach der Trennstelle ausgekreuzt ist, und zwei voneinander unabhängige Controller zur Verarbeitung der gemessenen Spannungen der Phasen gegenüber dem Neutralleiter vor und nach der Trennstelle vorgesehen sind, welche Controller über einen Datenbus miteinander verbunden sind, und die Controller zur Ableitung der Funktionalität der Schaltkontakte in jedem Schaltzustand über den Vergleich der gemessenen Spannungen mit in einer Auswertetabelle zugeordneten Messwerten ausgebildet sind.

Gemäß einem Merkmal der Erfindung ist ein Controller mit zwei Relais auf der Eingangsseite der Trennstelle verbunden zur Steuerung der Schaltkontakte dieser Relais und zur Verarbeitung der vor der Trennstelle gemessenen Spannungen, und der zweite unabhängige Controller mit zwei Relais auf der Ausgangsseite der Trennstelle verbunden zur Steuerung der Schaltkontakte dieser Relais und zur Verarbeitung der nach der Trennstelle gemessenen Spannungen.

Die vorliegende Erfindung wird anhand der beigefügten schematischen Zeichnungen näher erläutert. Darin zeigen:
- Fig. 1: eine schematische Übersichtsdarstellung eines Wechselrichters einer Photovoltaikanlage;
- Fig. 2: einen Aufbau einer Trennstelle zwischen einem Photovoltaik-Wechselrichter und einem Energieversorgungsnetz mit vier zweipoligen Relais als Schalter;
- Fig. 3: eine Tabelle mit dem Schaltmuster für die Prüfung der Schaltkontakte der Trennstelle gemäß Fig. 2;
- Fig. 4: einen alternativen Aufbau einer Trennstelle zwischen einem Photovoltaik-Wechselrichter und einem Energieversorgungsnetz mit zwei dreipoligen Relais und zwei einpoligen Relais; und
- Fig. 5: eine Tabelle mit dem Schaltmuster für die Prüfung der Schaltkontakte der Trennstelle gemäß Figur 4.

Einführend wird festgehalten, dass gleiche Teile des Ausführungsbeispiels mit gleichen Bezugszeichen versehen werden.

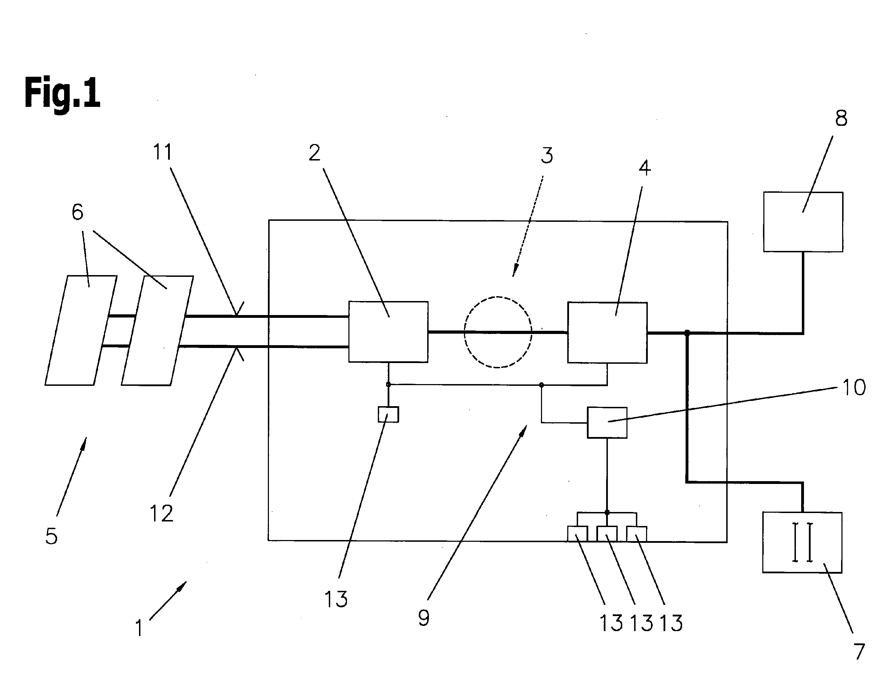

In Fig. 1 ist ein Aufbau eines bekannten Photovoltaik-Wechselrichters 1, im Detail eines HF-Wechselrichters, dargestellt. Da die einzelnen Komponenten bzw. Baugruppen und Funktionen von Photovoltaik-Wechselrichtern 1 bereits aus dem Stand der Technik bekannt sind, wird auf diese nachstehend nicht im Detail eingegangen.

Der Photovoltaik-Wechselrichter 1 weist zumindest einen Eingangs-DC-DC-Wandler 2, einen Zwischenkreis 3 und einen Ausgangs-DC-AC-Wandler 4 auf. Am Eingangs-DC-DC-Wandler 2 ist eine Energiequelle 5 bzw. ein Energieerzeuger angeschlossen, welche bevorzugt aus einem oder mehreren parallel und/oder seriell zueinander geschalteten Solarmodulen 6 gebildet werden. Der Photovoltaik-Wechselrichter 1 und die Solarmodule 6 werden auch als Photovoltaikanlage bzw. als PV-Anlage bezeichnet. Der Ausgang des Photovoltaik-Wechselrichters 1 bzw. des Ausgangs-DC-AC-Wandlers 4 kann mit einem Energieversorgungsnetz 7, wie einem öffentlichen oder privaten Wechselspannungsnetz oder einem Mehr-Phasennetz, und/oder mit zumindest einem elektrischen Verbraucher 8, welcher eine Last darstellt, verbunden sein. Beispielsweise wird ein Verbraucher 8 durch einen Motor, Kühlschrank, Funkgerät usw. gebildet. Ebenso kann der Verbraucher 8 auch eine Hausversorgung darstellen. Die einzelnen Komponenten des Photovoltaik-Wechselrichters 1, wie der Eingangs-DC-DC-Wandler 2 usw., können über einen Datenbus 9 mit einer Steuervorrichtung 10 verbunden sein.

Bevorzugt dient ein derartiger Photovoltaik-Wechselrichter 1 als so genannter netzgekoppelter Photovoltaik-Wechselrichter 1, dessen Energiemanagement daraufhin optimiert ist, möglichst viel Energie in das Energieversorgungsnetz 7 einzuspeisen. Wie aus dem Stand der Technik bekannt, werden die Verbraucher 8 über das Versorgungsnetz 7 versorgt. Selbstverständlich können auch mehrere parallel geschaltete Photovoltaik-Wechselrichter 1 eingesetzt werden. Dadurch kann mehr Energie zum Betrieb der Verbraucher 8 bereitgestellt werden. Diese Energie wird von der Energiequelle 5 in Form einer Gleichspannung geliefert, welche über zwei Anschlussleitungen 11, 12 mit dem Photovoltaik-Wechselrichter 1 verbunden ist.

Die Steuervorrichtung 10 bzw. der Regler des Photovoltaik-Wechselrichters 1 ist beispielsweise durch einen Mikroprozessor, Mikrocontroller oder Rechner gebildet. Über die Steuervorrichtung 10 kann eine entsprechende Steuerung der einzelnen Komponenten des Photovoltaik-Wechselrichters 1, wie dem Eingangs-DC-DC-Wandler 2 oder dem Ausgangs-DC-AC-Wandler 4, insbesondere der darin angeordneten Schaltelemente, vorgenommen werden. In der Steuervorrichtung 10 sind hierzu die einzelnen Regel- bzw. Steuerabläufe durch entsprechende Software-Programme und/oder Daten bzw. Kennlinien gespeichert.

Des Weiteren sind mit der Steuervorrichtung 10 Bedienelemente 13 verbunden, durch welche der Benutzer beispielsweise den Photovoltaik-Wechselrichter 1 konfigurieren und/oder Betriebszustände oder Parameter anzeigen (beispielsweise mittels Leuchtdioden) und einstellen kann. Die Bedienelemente 13 sind dabei beispielsweise über den Datenbus 9 oder direkt mit der Steuervorrichtung 10 verbunden. Derartige Bedienelemente 13 sind beispielsweise an einer Front des Photovoltaik-Wechselrichters 1 angeordnet, sodass eine Bedienung von außen möglich ist. Ebenso können die Bedienelemente 13 auch direkt an Baugruppen und/oder Modulen innerhalb des Photovoltaik-Wechselrichters 1 angeordnet sein. Bei Verwendung eines Photovoltaik-Wechselrichters 1 zur Einspeisung in ein Energieversorgungsnetz 7 ist es normativ (zum Beispiel laut E DIN VDE 0128) notwendig, eine Trennstelle 14 zwischen dem Photovoltaik-Wechselrichter 1 und dem Energieversorgungsnetz 7 zwischenzuschalten. Diese Trennstelle 14 muss vor dem Aufschalten des Photovoltaik-Wechselrichters 1 auf das Energieversorgungsnetz 7 auf die ordnungsgemäße Funktion überprüft werden.

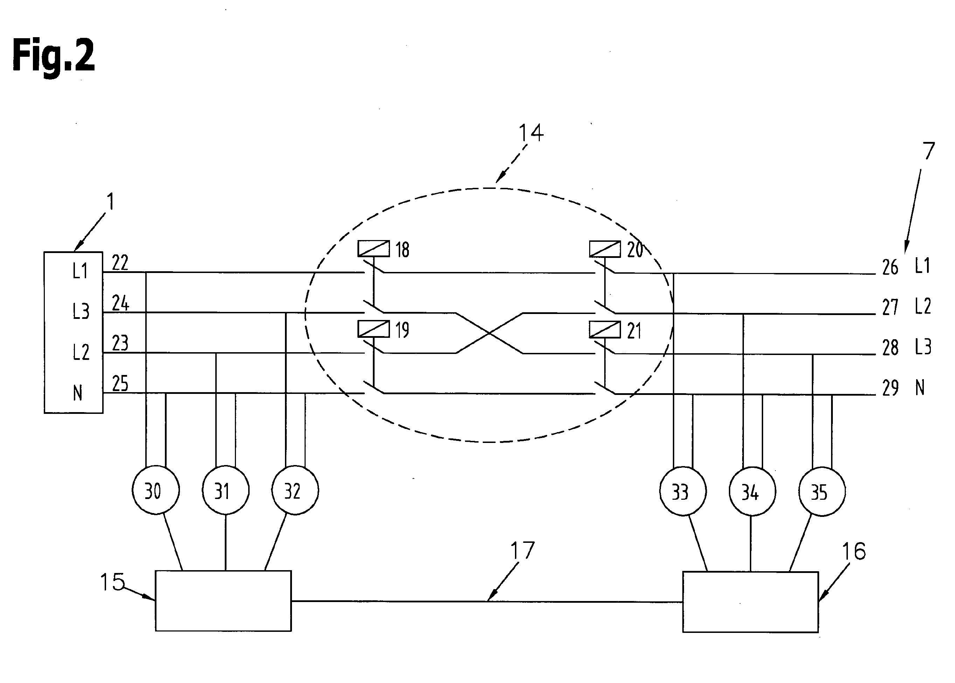

Erfindungsgemäß weist die Trennstelle 14 zwischen dem Photovoltaik-Wechselrichter 1 und dem Energieversorgungsnetz 7 vier zweipolige Relais 18, 19, 20 und 21 auf. Jedes dieser Relais 18-21 hat eine Steuerspule und zwei damit geschaltete Schaltkontakte. Durch die erfindungsgemäße Trennstelle 14 dieser Relais 18-21 gemäß Fig. 2 ergibt sich für jede Leitung zwischen Photovoltaik-Wechselrichter 1 und Versorgungsnetz 7 eine Reihenschaltung aus zwei, jeweils unabhängig voneinander steuerbaren Schaltkontakten. Der Anschluss 22 der Phase L1 auf der Seite des Photovoltaik-Wechselrichters 1 wird über die ersten Kontakte der Relais 18 und 20 mit dem Anschluss 26 der Phase L1 des Energieversorgungsnetzes 7 verbunden. Der Anschluss 23 der Phase L2 auf der Seite des Photovoltaik-Wechselrichters 1 wird über den ersten Kontakt des Relais 19 und den zweiten Kontakt des Relais 20 mit dem Anschluss 27 der Phase L2 des Versorgungsnetzes 7 verbunden. Der Anschluss 24 der Phase L3 auf der Seite des Photovoltaik-Wechselrichters 1 wird über den zweiten Kontakt des Relais 18 und den ersten Kontakt des Relais 21 mit dem Anschluss 28 der Phase L3 des Energieversorgungsnetzes 7 verbunden. Somit sind die Phasen L2 und L3 ausgekreuzt. Der Anschluss 25 des Neutralleiters auf der Seite des Photovoltaik-Wechselrichters 1 wird über den zweiten Kontakt des Relais 19 und den zweiten Kontakt des Relais 21 mit dem Anschluss 29 des Neutralleiters des Energieversorgungsnetzes 7 verbunden. Durch eine derartige Verschaltung mit Auskreuzung der Phasen L2 und L3 wird erreicht, dass bei den einzelnen Schaltzuständen der Relais 18-21 unterschiedliche Spannungen vor und nach der Trennstelle 14 gemessen werden können und entsprechend auf die Funktionalität der Trennstelle 14 rückgeschlossen werden kann.

Die Spannungsmessung erfolgt zum Beispiel mit Hilfe eines Differenzverstärkers, der die Messwertaufbereitung für die Messeinheit, welche zum Beispiel als Mikrocontroller mit Analog/Digital-Wandler ausgeführt werden kann, der die Messung der Spannungen an den einzelnen Phasen L1, L2, L3 gegenüber den Neutralleiter N vornimmt.

Durch diese Schaltanordnung können die einzelnen Schaltkontakte der Trennstelle 14 über Messung der Spannungen 30, 31 und 32 zwischen den Phasen L1, L2 und L3 und dem Neutralleiter N vor der Trennstelle 14 und Messung der Spannungen 33, 34 und 35 zwischen den Phasen L1, L2 und L3 und dem Neutralleiter N nach der Trennstelle 14 und einem Vergleich dieser Spannungen 30-35 überprüft werden. Die Spannungen werden entweder über das Energieversorgungsnetz 7 zur Verfügung gestellt, oder im Fall eines Inselwechselrichters vom Photovoltaik-Wechselrichter 1. Die Messspannung entspricht also der Phasenspannung. Die Messungen der Spannungen 30, 31, 32 erfolgen vor der Trennstelle 14 an den jeweiligen Anschlüssen 22, 23, 24 der Phasen L1, L2, L3 gegenüber dem Anschluss 25 des Neutralleiters N auf der Seite des Photovoltaik-Wechselrichters 1. Die Messungen der Spannungen 33, 34, 35 erfolgen nach der Trennstelle 14 an den jeweiligen Anschlüssen 26, 27, 28 der Phasen L1, L2, L3 gegenüber dem Anschluss 29 des Neutralleiters N auf der Seite des Energieversorgungsnetzes 7.

Die gemessenen Spannungen 30, 31, 32 bzw. 33, 34, 35 vor und nach der Trennstelle 14 werden durch zwei voneinander unabhängige Controller 15 und 16 verarbeitet, welche über einen Datenbus 17 miteinander kommunizieren können. Durch die Controller 15, 16 werden auch jeweils zwei der vier Relais 18-21 gesteuert.

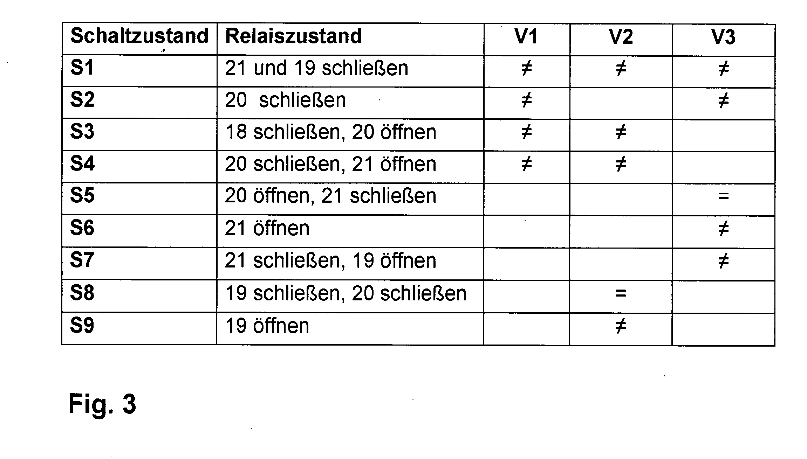

Das erfindungsgemäße Verfahren zur Prüfung der einzelnen Schaltkontakte der Relais 18-21 wird beispielsweise durch eine entsprechende Software realisiert. Um die Prüfung der einzelnen Schaltkontakte der Trennstelle 14 durchzuführen, kann beispielsweise das in der Tabelle gemäß Fig. 3 dargestellte Schaltmuster in Kombination mit der darin dargestellten Auswertetabelle verwendet werden. Wenn im jeweiligen Schaltzustand das zugehörige Messergebnis gemäß der Auswertetabelle erfüllt ist, ist die Funktionalität der Schaltkontakte der Trennstelle 14 gegeben.

In der Tabelle gemäß Fig. 3 sind sämtliche Schaltzustände S1 bis S9 beschrieben, welche bei der Prüfung durchlaufen werden. Der Wechsel von einem Schaltzustand in den nächsten Schaltzustand erfolgt durch schrittweise Schaltung der Relais 18-21, wobei die Ansteuerung zur Schaltung von den Controllern 15, 16 durchgeführt wird. In jedem der Schaltzustände S1 bis S9 werden nun die Spannungen 30-32 an den Anschlüssen 22-24 der Phasen L1, L2, L3 gegenüber dem Anschluss 25 des Neutralleiters N am Eingang der Trennstelle 14 mit den Spannungen 33-35 an den Anschlüssen 26-28 der Phasen L1, L2, L3 gegenüber dem Anschluss 29 des Neutralleiters N am Ausgang der Trennstelle 14 verglichen. Dieser Vergleich wird von den Controllern 15, 16 durchgeführt, wobei jeweils die Spannungen der gleichen Phase L1, L2, L3 miteinander verglichen wird. Entsprechend liegt an einer Seite der Trennstelle 14 immer ein Spannungswert an. An welcher Seite die Spannung anliegt hängt davon ab, ob die Spannung für die Messung vom Energieversorgungsnetz 7 oder vom Photovoltaik-Wechselrichter 1 zur Verfügung gestellt wird. An der jeweils anderen Seite der Trennstelle 14 wird nur dann ein Spannungswert gemessen, wenn die entsprechenden Relais 18-21 geschaltet sind. Durch dieses Messverfahren bzw. Prüfverfahren kann festgestellt werden, ob alle Schaltkontakte der Trennstelle 14 geschlossen und wieder geöffnet werden können. Zusätzlich zu den unten beschriebenen Schaltzuständen S1-S9, welche für die Prüfung der einzelnen Schaltkontakte der Relais 18-21 relevant sind, werden fünf weitere Schaltzustände, die während des Wechsels der Schaltzustände S1-S9 auftreten, benötigt.

Im Ausgangszustand des erfindungsgemäßen Verfahrens zur Prüfung der Schaltkontakte sind sämtliche Schaltkontakte der Relais 18-21 geöffnet. In diesem Zustand findet noch keine Messung statt. Um in den ersten Schaltzustand S1 zu wechseln werden die Relais 21 und 19 geschlossen. Im Schaltzustand S1 muss nun die Spannung 30 der Phase L1 vor der Trennstelle 14 ungleich der Spannung 33 der Phase L1, die Spannung 31 der Phase L2 vor der Trennstelle 14 ungleich der Spannung 34 der Phase L2 nach der Trennstelle 14 und die Spannung 32 der Phase L3 vor der Trennstelle 14 ungleich der Spannung 35 der Phase L3 nach der Trennstelle 14 sein, da die Verbindungen zwischen den einzelnen Phasen L1, L2, L3 vor und nach der Trennstelle 14 unterbrochen sein müssen. Entspricht ein Vergleich nicht dem festgelegten Sollzustand so ist das ein Hinweis darauf, dass ein Schaltkontakt eines Relais 18 oder 20 geschlossen ist bzw. klebt und nicht geöffnet werden konnte. Die Funktionalität der Trennstelle 14 ist somit nicht gegeben.

Um in den nächsten Schaltzustand S2 zu wechseln, wird das Relais 20 geschlossen, alle übrigen Relais 18, 19, 21 bleiben im vorhergehenden Schaltzustand. In diesem Schaltzustand wird nun geprüft, ob die Spannungen 30 und 33 ungleich sind, da Relais 18 geöffnet sein muss. Trifft dies nicht zu, so ist der erste Schaltkontakt des Relais 18 defekt. Weiters muss geprüft werden, ob die Spannungen 32 und 35 ungleich sind. Trifft dies nicht zu, so ist der zweite Schaltkontakt des Relais 18 defekt. Zusätzlich wird geprüft ob die Spannungen 31 und 34 gleich sind. Ist dies nicht der Fall hat der zweite Schaltkontakt des Relais 20 nicht korrekt geschlossen.

Um in den nächsten Schaltzustand S3 zu wechseln, wird das Relais 18 geschlossen und das Relais 20 geöffnet. In diesem Zustand wird nun geprüft, ob die Spannungen 30 und 33 ungleich sind, und ob die Spannungen 31 und 34 ungleich sind. Da das Relais 20 jeweils die Schaltkontakte zwischen diesen Phasen öffnet, muss diese Bedingung erfüllt sein. Ist die Ungleichheit in einem der beiden Vergleiche nicht gegeben, so klebt bei Gleichheit der Spannungen 30 und 33 der erste Schaltkontakt des Relais 20 und bei Gleichheit der Spannungen 31 und 34 der zweite Schaltkontakt des Relais 20. Die Spannungen 32 und 35 sind in diesem Zustand gleich, da die Relais 18 und 21 geschlossen sind. Demnach werden die Schaltkontakte in einem der folgenden Schaltzustände überprüft.

Um in den nächsten Schaltzustand S4 zu wechseln, wird das Relais 20 geschlossen und das Relais 21 geöffnet. In diesem Zustand muss für eine korrekte Funktion der Schaltkontakte der Trennstelle 14 die Spannung 30 ungleich der Spannung 33 und die Spannung 31 ungleich der Spannung 34 sein. Ist eine der beiden Bedingungen nicht erfüllt, so klebt der zweite Schaltkontakt des Relais 21. Diese Aussage kann deshalb getroffen werden, weil an den zweiten Schaltkontakt des Relais 21 die Spannung am Anschluss 29 bzw. Anschluss 25 geschaltet wird und in den vorigen Schaltzuständen bereits erfolgreich überprüft wurde, dass die Schaltkontakte der Relais 20 und 21 zumindest korrekt geschlossen werden können.

Um in den nächsten Schaltzustand S5 zu wechseln, wird Relais 20 geöffnet und Relais 21 geschlossen. In diesem Schaltzustand müssen die Spannungen 32 und 35 gleich sein. Ist dies nicht der Fall, so konnte der erste Schaltkontakt des Relais 21 nicht korrekt geschlossen werden. Die restlichen Spannungen müssen in diesem Schaltzustand S5 nicht verglichen werden, da dadurch keine zusätzlichen Aussagen über die Funktionalität der Schaltkontakte getroffen werden können.

Um in den nächsten Schaltzustand S6 zu wechseln, wird Relais 21 geöffnet. In diesem Schaltzustand wird geprüft, ob die Spannungen 32 und 35 ungleich sind. Sind diese beiden Spannungen 32 und 35 gleich, so kann auf einen klebenden ersten Schaltkontakt von Relais 21 geschlossen werden, da bei einem Öffnen dieses Schaltkontakts die Spannungen ungleich sein müssten. Aus den restlichen Spannungsmessungen können in diesem Schaltzustand S6 keine weiteren relevanten Informationen gewonnen werden.

Um in den nächsten Schaltzustand S7 zu wechseln, wird das Relais 21 geschlossen und das Relais 19 geöffnet. In diesem Schaltzustand wird geprüft, ob die Spannungen 32 und 35 ungleich sind. Trifft dies nicht zu, so klebt der zweite Schaltkontakt von Relais 19, da durch diesen für eine der beiden Messungen (welche hängt davon ab, welche Seite der Trennstelle 14 mit der Spannung versorgt wird) die Spannungen an den Anschlüssen 25 oder 29 weggeschaltet werden müsste. Das korrekte Schließen der zweiten Schaltkontakts des Relais 19 und des zweiten Schaltkontakts des Relais 21 wurde bereits durch Sicherstellen der Gleichheit der Spannung 32 und 35 im Schaltzustand S5 geprüft. Die übrigen Spannungen sind in diesem Schaltzustand S5 für keine weitere Prüfung relevant.

Um in den nächsten Schaltzustand S8 zu wechseln, werden die Relais 19 und 20 geschlossen. In diesem Schaltzustand wird geprüft ob die Spannungen 31 und 34 gleich sind. Ist dies nicht der Fall, so kann darauf geschlossen werden, dass der erste Schaltkontakt des Relais 19 nicht korrekt geschlossen wurde. Diese Aussage kann deshalb getroffen werden, da der zweite Schaltkontakt des Relais 21 im Schaltzustand S4 und der zweite Schaltkontakt des Relais 20 im Schaltzustand S3 bereits geprüft wurde und somit bei Nichterfüllung der Bedingung der erste Schaltkontakt des Relais 19 kleben muss. Die übrigen Spannungen bringen in diesem Schaltzustand S8 keine weiteren Informationen.

Um in den letzten Schaltzustand S9 zu wechseln, wird das Relais 19 geöffnet. In diesem Schalzustand muss die Spannung 31 ungleich mit der Spannung 34 sein. Trifft dies nicht zu, so klebt der erste Schaltkontakt des Relais 19. Diese Aussage kann getroffen werden, da die korrekte Funktion des zweiten Schaltkontakts des Relais 19 bereits im Schaltzustand S8 und die Funktionstüchtigkeit der ersten und zweiten Schaltkontakte der Relais 18, 20 und 21 in den vorigen Schaltzuständen überprüft wurde. Die übrigen Spannungen sind in diesem Schaltzustand S9 für keine weiteren Informationen relevant.

Es werden also die Relais 18 bis 21 der Trennstelle 14 mit jedem Schaltzustand S1-S9 entsprechend umgeschaltet, wobei der Schaltzustand vom vorhergehenden Schaltzustand erhalten bleibt, falls dieser mit dem aktuellen Schaltzustand nicht geändert wird. Grundsätzlich werden immer die Spannungen 30-35 aller Phasen L1-L3 in jedem Schaltzustand gemessen, wobei für die Prüfung der Funktionalität der Schaltkontakte die Spannungen gemäß der Auswertetabelle übereinstimmen müssen.

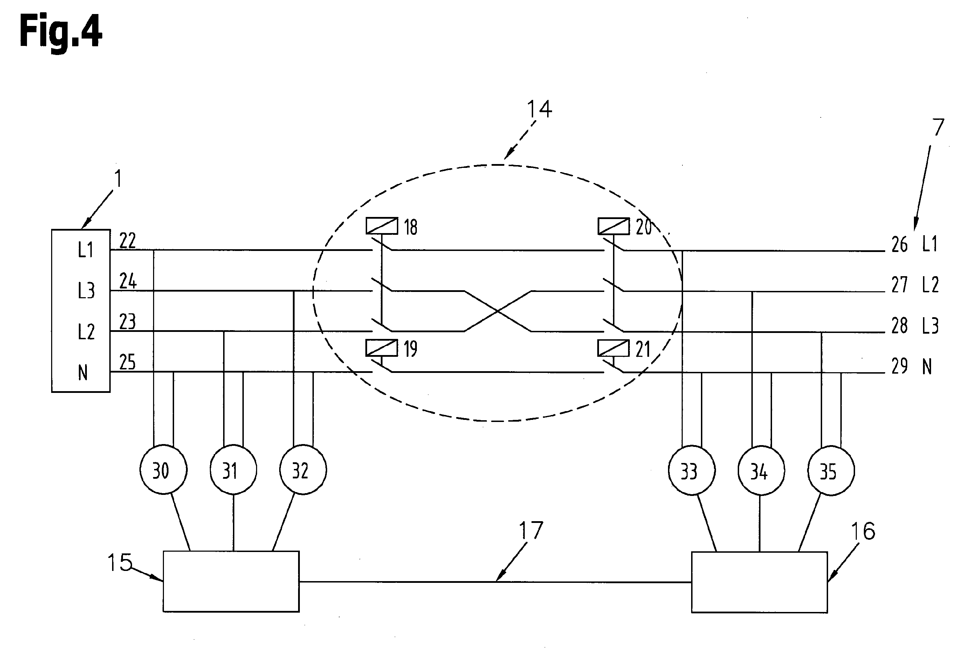

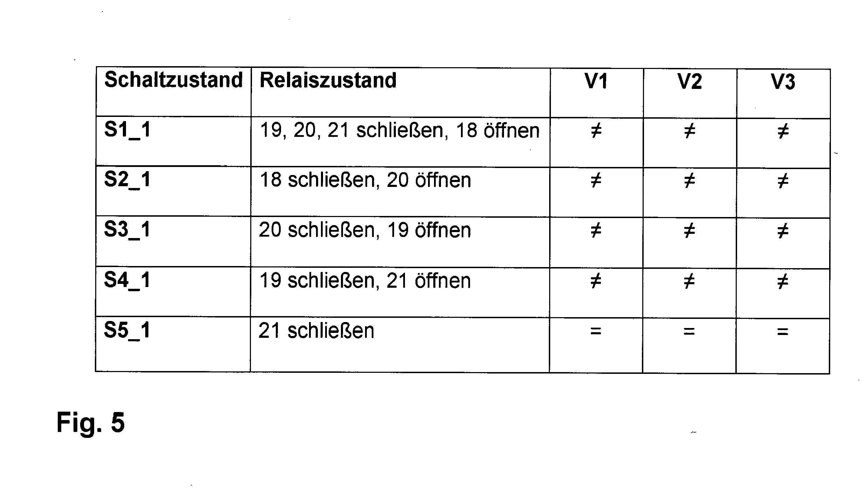

Erfindungsgemäß kann die Trennstelle 14 auch mit zwei dreipoligen Relais 18 und 20 und zwei einpoligen Relais 19 und 21 realisiert werden, wie in Fig. 4 dargestellt. Die Prüfung der Trennstelle 14 auf klebende Schaltkontakte erfolgt hier ebenfalls durch Vergleich der gemessenen Spannungen 30, 31, 32 und 33, 34, 35 vor und nach der Trennstelle 14. Hierzu wird auch bei dieser Schaltungsvariante ein Schaltmuster durchlaufen, dessen Zustände in der Tabelle gemäß Fig. 5 dargestellt sind.

Der Wechsel von einem Schaltzustand in den nächsten erfolgt durch schrittweise Schaltung von zumindest einem der Relais 18-21, wobei die Ansteuerung zur Schaltung von den Controllern 15, 16 durchgeführt werden kann.

Diese Variante des Prüfverfahrens startet im Ausgangszustand S1_1. In diesem sind die Relais 19, 20 und 21 geschlossen und das Relais 18 geöffnet. In diesem Schaltzustand müssen die Spannungen 30 und 33 ungleich sein. Ist dies nicht der Fall, so klebt der erste Schaltkontakt des Relais 18. Außerdem müssen die Spannungen 31 und 34 ungleich sein. Ist dies nicht der Fall, so klebt der dritte Schaltkontakt des Relais 18. Weiters müssen die Spannungen 32 und 35 ungleich sein. Ist dies nicht der Fall, so klebt der zweite Schaltkontakt des Relais 18. Diese Aussagen können getroffen werden, da die Verbindung aller Anschlüsse 22-24 vor der Trennstelle zu den Anschlüssen 26-28 nach der Trennstelle 14 über das Relais 18 unterbrochen sein müssen. Somit werden in diesem Schaltzustand S1_1 alle Schaltkontakte des Relais 18 überprüft.

Um in den nächsten Schaltzustand S2_1 zu wechseln, wird das Relais 18 geschlossen und das Relais 20 geöffnet. In diesem Schaltzustand müssen die Spannungen 30 und 33 ungleich sein. Ist dies nicht der Fall, so klebt der erste Schaltkontakt des Relais 20. Außerdem müssen die Spannungen 31 und 34 ungleich sein. Ist dies nicht der Fall, so klebt der zweite Schaltkontakt des Relais 20. Weiters müssen die Spannungen 32 und 35 ungleich sein. Ist dies nicht der Fall, so klebt der dritte Schaltkontakt des Relais 20. Diese Aussagen können getroffen werden, da die Anschlüsse 22-24 vor der Trennstelle 14 von den Anschlüssen 26-28 nach der Trennstelle über das Relais 20 unterbrochen sein müssen.

Um in den nächsten Schaltzustand S3_1 zu wechseln, wird das Relais 20 geschlossen und das Relais 19 geöffnet. In diesem Schaltzustand müssen die Spannungen 30 und 33 ungleich sein. Ist dies nicht der Fall, so klebt der erste Schaltkontakt des Relais 19. Außerdem müssen die Spannungen 31 und 34 und die Spannungen 32 und 35 ungleich sein. Diese Aussagen können getroffen werden, da der Anschluss 25 vor der Trennstelle 14 vom Anschluss 29 nach der Trennstelle 14 durch das das Relais 19 unterbrochen sein muss. Somit müssen sämtliche Spannungen 30-32 am Eingang der Trennstelle 14 von den Spannungen 33-35 am Ausgang der Trennstelle 14 unterschiedlich sein.

Um in den Schaltzustand S4_1 zu wechseln, wird das Relais 19 geschlossen und das Relais 21 geöffnet. In diesem Schaltzustand müssen die Spannungen 30 und 33 ungleich sein. Ist dies nicht der Fall, so klebt der erste Schaltkontakt des Relais 21. Außerdem müssen die Spannungen 31 und 34 und auch die Spannungen 32 und 35 ungleich sein. Diese Aussagen können getroffen werden, da der Anschluss 25 vor der Trennstelle 14 und der Anschluss 29 nach der Trennstelle 14 durch das Relais 21 unterbrochen sein muss. Somit müssen sämtliche Spannungen 30-32 am Eingang der Trennstelle 14 unterschiedlich zu den Spannungen 33-35 am Ausgang der Trennstelle 14 sein.

Um in den letzten Schaltzustand S5_1 zu wechseln, wird das Relais 21 geschlossen. In diesem Schaltzustand müssen die Spannungen 30 und 33 gleich sein, die Spannungen 31 und 34 gleich sein und die Spannungen 32 und 35 gleich sein. Da in diesem Schaltzustand sämtliche Relais 18-21 geschlossen sind, müssen sämtliche Phasen L1, L2, L3 und der Neutralleiter N durchgeschaltet sein.

Äquivalent zum ersten Ausführungsbeispiel gemäß Fig. 2 sind auch hier zwei Phasen L2 und L3 ausgekreuzt.

## Patentansprüche

1. Verfahren zur Prüfung einer Trennstelle (14) eines Photovoltaik-Wechselrichters (1) zu einem Energieversorgungsnetz (7) mit mehreren Phasen (L1, L2, L3) und einem Neutralleiter (N), wobei mehrere Schaltkontakte mehrerer Relais (18-21) der Trennstelle (14) vom Photovoltaik-Wechselrichter (1) angesteuert werden, und die Spannungen (30, 31, 32 und 33, 34, 35) an jeder Phase (L1, L2, L3) gegenüber dem Neutralleiter (N) jeweils vor und nach der Trennstelle (14) gemessen werden, **dadurch gekennzeichnet, dass** in der Trennstelle (14) zumindest eine Phase (L2, L3) vor der Trennstelle (14) und zumindest eine Phase (L2, L3) nach der Trennstelle (14) ausgekreuzt wird, und die Schaltkontakte der Trennstelle (14) nach einem Schaltmuster schrittweise geschaltet und geprüft werden, wobei das Schaltmuster durch schrittweisen Wechsel der Schaltkontakte der Trennstelle (14) von einem Schaltzustand in einen anderen Schaltzustand realisiert wird, und jedem Schaltzustand ein Messergebnis gemäß einer Auswertetabelle zugeordnet wird, und in jedem Schaltzustand des Schaltmusters die Funktionalität der Schaltkontakte der Trennstelle (14) abgeleitet wird, indem bei jedem Schaltzustand die Spannungen (30, 31, 32 und 33, 34, 35) an zumindest einer Phase (L1, L2, L3) gegenüber dem Neutralleiter (N) jeweils vor und nach der Trennstelle (14) gemessen und mit den Messergebnissen der Auswertetabelle verglichen werden.

2. Verfahren nach Anspruch 1, **dadurch gekennzeichnet, dass** die Spannungen (30, 31, 32 und 33, 34, 35) vom Energieversorgungsnetz (7) zur Verfügung gestellt wird.

3. Verfahren nach Anspruch 1, **dadurch gekennzeichnet, dass** die Spannungen (30, 31, 32 und 33, 34, 35) vom Photovoltaik-Wechselrichter (1) zur Verfügung gestellt wird.

4. Verfahren nach einem der Ansprüche 1 bis 3, **dadurch gekennzeichnet, dass** die gemessenen Spannungen (30, 31, 32 und 33, 34, 35) vor und nach der Trennstelle (14) durch zwei voneinander unabhängige Controller (15, 16) verarbeitet werden, welche Controller (15, 16) über einen Datenbus (17) miteinander verbunden werden.

5. Photovoltaik-Wechselrichter (1) zur Umwandlung einer Gleichspannung in eine Wechselspannung mit mehreren Phasen (L1, L2, L3) und einem Neutralleiter (N) und zur Einspeisung der Wechselspannung in ein Energieversorgungsnetz (7) mit mehreren Phasen (L1, L2, L3) und einem Neutralleiter (N), mit einer Trennstelle (14) aus mehreren Relais (18-21) mit mehreren Schaltkontakten zur galvanischen Trennung zu den Phasen (L1, L2, L3) und dem Neutralleiter (N) des Energieversorgungsnetzes (7), wobei Einrichtungen zur Messung der Spannungen (30, 31, 32 und 33, 34, 35) der Phasen (L1, L2, L3) gegenüber dem Neutralleiter (N) vor und nach der Trennstelle (14) vorgesehen sind, **dadurch gekennzeichnet, dass** die Trennstelle (14) aus vier Relais (18-21) mit jeweils zumindest einem Schaltkontakt besteht, wobei für jeden Anschluss der Phasen (L1, L2, L3) und des Neutralleiters (N) jeweils zwei Schaltkontakte von zwei voneinander unabhängig schaltbaren Relais (18-21) miteinander in Reihe geschaltet sind, und dass in der Trennstelle (14) zumindest eine Phase (L2, L3) vor der Trennstelle (14) und zumindest eine Phase (L2, L3) nach der Trennstelle (14) ausgekreuzt ist, und dass zwei voneinander unabhängige Controller (15, 16) zur Verarbeitung der gemessenen Spannungen (30, 31, 32 und 33, 34, 35) der Phasen (L1, L2, L3) gegenüber dem Neutralleiter (N) vor und nach der Trennstelle (14) vorgesehen sind, welche Controller (15, 16) über einen Datenbus (17) miteinander verbunden sind, und die Controller (15, 16) zur Ableitung der Funktionalität der Schaltkontakte in jedem Schaltzustand über den Vergleich der gemessenen Spannungen (30, 31, 32 und 33, 34, 35) mit in einer Auswertetabelle zugeordneten Messwerten ausgebildet sind.

6. Photovoltaik-Wechselrichter (1) nach Anspruch 5, **dadurch gekennzeichnet, dass** ein Controller (15) mit zwei Relais (18, 19) auf der Eingangsseite der Trennstelle (14) verbunden ist zur Steuerung der Schaltkontakte dieser Relais (18, 19) und zur Verarbeitung der vor der Trennstelle (14) gemessenen Spannungen (30, 31, 32), und dass der zweite unabhängige Controller (16) mit zwei Relais (20, 21) auf der Ausgangsseite der Trennstelle (14) verbunden ist zur Steuerung der Schaltkontakte dieser Relais (20, 21) und zur Verarbeitung der nach der Trennstelle (14) gemessenen Spannungen (33, 34, 35).

## Claims

1. A method for checking a photovoltaic inverter separator (14) between the photovoltaic inverter (1) and a power supply network (7), comprising multiple phases (L1, L2, L3) and a neutral conductor (N), wherein multiple switching contacts of multiple relays (18-21) of the separator (14) are controlled by the photovoltaic inverter (1), and each voltage (30, 31, 32 and 33, 34, 35) at each phase (L1, L2, L3) is measured upstream and downstream of the separator (14) in relation to the neutral conductor (N), **characterized in that** in the separator (14) at least one phase (L2, L3) upstream of the separator (14) and at least one phase (L2, L3) downstream of the separator (14) is cross-bonded, and that the switching contacts of the separator (14) are connected and checked in steps according to a switching pattern, wherein the switching pattern is implemented by a stepwise change of the switching contacts of the separator (14) from one switching state to another switching state, and that each switching state is assigned a measurement result in accordance with an evaluation table, and the functionality of the switching contacts of the separator (14) is derived in each switching state of the switching pattern **in that**, in each switching state, each voltage (30, 31, 32 and 33, 34, 35) is measured at at least one phase (L1, L2, L3) upstream and downstream of the separator (14) in relation to the neutral conductor (N), and the voltages are compared to the measurement results of the evaluation table.

2. The method according to claim 1, **characterized in that** the voltages (30, 31, 32 and 33, 34, 35) are supplied by the power supply network (7).

3. The method according to claim 1, **characterized in that** the voltages (30, 31, 32 and 33, 34, 35) are supplied by the photovoltaic inverter (1).

4. The method according to any of claims 1 to 3, **characterized in that** the voltages (30, 31, 32 and 33, 34, 35) measured upstream and downstream of the separator (14) are processed by two independent controllers (15, 16), said controllers (15, 16) being connected with each other via a data bus (17).

5. A photovoltaic inverter (1) for converting a direct voltage to an alternating voltage with multiple phases (L1, L2, L3) and a neutral conductor (N), and for feeding the alternating voltage to a power supply network (7) with multiple phases (L1, L2, L3) and a neutral conductor (N), with a separator (14) of multiple relays (18-21) with multiple switching contacts for galvanic separation to the phases (L1, L2, L3) and the neutral conductor (N) of the power supply network (7), wherein means are provided for measuring the voltages (30, 31, 32 and 33, 34, 35) of the phases (L1, L2, L3) in relation to the neutral conductor (N) upstream and downstream of the separator (14), **characterized in that** the separator (14) consists of four relays (18-21) with at least one switching contact each, wherein every two switching contacts of two relays (18-21) that are switchable independently of each other are connected in series for each connection of the phases (L1, L2, L3) and of the neutral conductor (N), and that in the separator (14) at least one phase (L2, L3) upstream of the separator (14) and at least one phase (L2, L3) downstream of the separator (14) is cross-bonded, and that two independent controllers (15, 16) are provided for processing the voltages (30, 31, 32 and 33, 34, 35) of the phases (L1, L2, L3) measured upstream and downstream of the separator (14) in relation to the neutral conductor (N), said controllers being connected with each other via a data bus (17), and that the controllers (15, 16) are designed for deriving the functionality of the switching contacts in each switching state by comparing the measured voltages (30, 31, 32 and 33, 34, 35) with measurement values assigned in an evaluation table.

6. The photovoltaic inverter (1) according to claim 5, **characterized in that** a controller (15) is connected with two relays (18, 19) at the input side of the separator (14) for controlling the switching contacts of theses relays (18, 19) and for processing the voltages (30, 31, 32) measured upstream of the separator (14), and that the second independent controller (16) is connected with two relays (20, 21) at the output side of the separator (14) for controlling the switching contacts of these relays (20, 21) and for processing the voltages (33, 34, 35) measured downstream of the separator (14).

## Revendications

1. Procédé de contrôle d'un point d'isolation (14) entre un onduleur photovoltaïque (1) et un réseau d'alimentation en énergie (7) avec plusieurs phases (L1, L2, L3) et un conducteur neutre (N), plusieurs contacts de commutation de plusieurs relais (18-21) du point d'isolation (14) étant commandés par le onduleur photovoltaïque (1) et les tensions (30, 31, 32 et 33, 34, 35) au niveau de chaque phase (L1, L2, L3) par rapport au conducteur neutre (N) sont mesurées chacune avant et après le point d'isolation (14), **caractérisé en ce que**, au niveau du point d'isolation (14), au moins une phase (L2, L3) avant le point d'isolation (14) et au moins une phase (L2, L3) après le point d'isolation (14) est permutée et les contacts de commutation du point d'isolation (14) sont commutés et contrôlés par étapes selon un modèle de commutation, le modèle de commutation étant réalisé par le passage par étapes des contacts de commutation du point d'isolation (14) d'un état de commutation à un autre état de commutation et, à chaque état de commutation correspond un résultat de mesure selon un tableau d'analyse et, dans chaque état de commutation du modèle de commutation, la fonctionnalité des contacts de commutation du point d'isolation (14) étant déduite en mesurant, pour chaque état de commutation, les tensions (30, 31, 32 et 33, 34, 35) au niveau d'au moins une phase (L1, L2, L3) par rapport au conducteur neutre (N) chacune avant et après le point d'isolation (14) et en les comparant avec les résultats de mesure du tableau d'analyse.

2. Procédé selon la revendication 1, **caractérisé en ce que** les tensions (30, 31, 32 et 33, 34, 35) sont fournies par le réseau d'alimentation en énergie (7).

3. Procédé selon la revendication 1, **caractérisé en ce que** les tensions (30, 31, 32 et 33, 34, 35) sont fournies par le onduleur photovoltaïque (1).

4. Procédé selon l'une des revendications 1 à 3, **caractérisé en ce que** les tensions (30, 31, 32 et 33, 34, 35) mesurées avant et après le point d'isolation (14) sont traitées par des contrôleurs (15, 16) indépendants entre eux, ces contrôleurs (15, 16) étant reliés entre eux par l'intermédiaire d'un bus de données (17).

5. Onduleur photovoltaïque (1) pour la conversion d'une tension continue en une tension alternative avec plusieurs phases (L1, L2, L3) et un conducteur neutre (N) et pour l'introduction de la tension alternative dans un réseau d'alimentation en énergie (7) avec plusieurs phases (L1, L2, L3) et un conducteur neutre (N), avec un point d'isolation (14) constitué de plusieurs relais (18-21) avec plusieurs contacts de commutation pour la séparation galvanique avec les phases (L1, L2, L3) et le conducteur neutre (N) du réseau d'alimentation en énergie (7), des dispositifs de mesure des tensions (30, 31, 32 et 33, 34, 35) des phases (L1, L2, L3) par rapport au conducteur neutre (N) avant et après le point d'isolation (14) étant prévus, **caractérisé en ce que** le point d'isolation (14) est constitué de quatre relais (18-21) avec chacun au moins un contact de commutation, deux contacts de commutation de relais (18-21) commutables de manière indépendante étant branchés entre eux en série pour chaque connexion des phases (L1, L2, L3) et du conducteur neutre (N), et **en ce que**, au niveau du point d'isolation (14), au moins une phase (L2, L3) est permutée avant le point d'isolation (14) et au moins une phase (L2, L3) est permutée après le point d'isolation (14), et **en ce que** deux contrôleurs (15, 16) indépendants l'un de l'autre sont prévus pour le traitement des tensions (30, 31, 32 et 33, 34, 35) des phases (L1, L2, L3) par rapport au conducteur neutre (N), mesurées avant et après le point d'isolation (14), ces contrôleurs (15, 16) étant reliés entre eux par l'intermédiaire d'un bus de données (17) et les contrôleurs (15, 16) sont conçus pour déduire la fonctionnalité des contacts de commutation dans chaque état de commutation grâce à la comparaison des tensions mesurées (30, 31, 32 et 33, 34, 35) avec des valeurs de mesure correspondantes dans un tableau d'analyse.

6. Onduleur photovoltaïque (1) selon la revendication 5, **caractérisé en ce qu'**un contrôleur (15) est relié avec deux relais (18, 19) du côté de l'entrée du point d'isolation (14) pour commander les contacts de commutation de ces relais (18, 19) et pour le traitement des tensions (30, 31, 32) mesurées avant le point d'isolation (14) et **en ce que** le deuxième contrôleur indépendant (16) est relié avec deux relais (20, 21) du côté de la sortie du point d'isolation (14) pour commander les contacts de commutation de ces relais (20, 21) et pour le traitement des tensions (33, 34, 35) mesurées après le point d'isolation (14).
